# EUROPÄISCHE PATENTSCHRIFT

(11) **EP 2 176 607 B1**
(45) Veröffentlichungstag und Bekanntmachung des Hinweises auf die Patenterteilung: **06.05.2015**
(21) Anmeldenummer: 08760629.9
(22) Anmeldetag: 06.06.2008
(51) Int. Cl.: F25D 19/00, G01N 1/42

(54) **TIEFTEMPERATURVORRICHTUNG**
LOW TEMPERATURE DEVICE
DISPOSITIF BASSE TEMPÉRATURE

(30) Priorität: 22.06.2007 DE 102007028865
(43) Veröffentlichungstag der Anmeldung: 21.04.2010
(73) Patentinhaber: HB Patent UG, 80337 München (DE)
(72) Erfinder: Bühler, Matthias, 82343 Pöcking (DE); Höhne, Jens, 80331 München (DE)
(74) Vertreter: Winter, Brandl, Fürniss, Hübner, Röss, Kaiser, Polte - Partnerschaft mbB
(86) Internationale Anmeldenummer: PCT/EP2008/057055
(87) Internationale Veröffentlichungsnummer: WO 2009/000629

(56) Entgegenhaltungen:
- US-A- 5 352 898
- US-A- 5 611 207
- MEYER G: "A SIMPLE LOW-TEMPERATURE ULTRAHIGH-VACUUM SCANNING TUNNELING MICROSCOPE CAPABLE OF ATOMIC MANIPULATION" REVIEW OF SCIENTIFIC INSTRUMENTS, AIP, MELVILLE, NY, US, Bd. 67, Nr. 8, 1. August 1996 (1996-08-01), Seiten 2960-2965, XP000620468 ISSN: 0034-6748

## Beschreibung

Die Erfindung betrifft eine Tieftemperaturvorrichtung gemäß dem Oberbegriff des Anspruch 1.

Derartige Tieftemperaturvorrichtungen werden in der Kryophysik und für Sensoren, die auf einem Tieftemperatureffekt basieren, eingesetzt. Derartige Tieftemperaturvorrichtungen sind z. B. aus der EP 1014056 A2 bekannt. Die bekannten Tieftemperaturvorrichtungen weisen einen Tieftemperaturbehälter mit wenigstens einer Untersuchungsöffnung auf. In dem Tieftemperaturbehälter ist eine Probenhalterung angeordnet, auf bzw. an der sich eine zu untersuchende Materialprobe anbringen lässt. Mittels einer Kühleinrichtung mit einem in dem Tieftemperaturbehälter angeordneten Kaltkopf kann eine an der Probenhalterung befestigte Probe auf die gewünschte Temperatur gekühlt werden. Die Probenhalterung bzw. die darauf angeordnete Probe ist so in dem Tieftemperaturbehälter angeordnet, dass die Probe durch die Untersuchungsöffnung einsehbar ist. Als Kühleinrichtung werden ein zweistufiger Pulsröhrenkühler und eine Entmagnetisierungsstufe eingesetzt. Es ist auch bekannt, anstelle der Entmagnetisierungsstufe einen 3He/4He-Entmischungskühler oder einen 3He-Kühler zu verwenden. Durch den Pulsröhrenkühler erfolgt eine Vorkühlung auf ca. 4 K, und durch die zweite Kühleinrichtung erfolgt eine Kühlung auf die Betriebstemperatur der auf einem Tieftemperatureffekt basierenden Sensoren im Bereich von 50 - 400 mK. Durch die zwei Kühlstufen und die extrem niedrigen Betriebstemperaturen der Sensoren sind der aparative Aufwand und damit der Preis derartiger Kryo-Detektorvorrichtungen enorm. Aufgrund der tiefen Betriebstemperaturen sind mehrere Infrarotfilter notwendig und im Bereich des Messrüssels viele Schilde, die wiederum einen großen Durchmesser des Messrüssels bedingen.

Eine ähnliche Tieftemperaturvorrichtung ist auch aus der DE 10317888 B3 bekannt.

Bei solchen Tieftemperaturvorrichtungen ist es häufig nötig, dass vibrationsempfindliche Untersuchungs- und Manipuliereinrichtungen an die Untersuchungsöffnung gekoppelt werden. Beispielsweise geschieht dies dadurch, dass die jeweilige Untersuchungsvorrichtung an die Untersuchungsöffnung angeflanscht wird. Durch diese mechanische Verbindung werden Vibrationen der Kühleinrichtung auch auf die Untersuchungseinrichtung übertragen, was bei einigen Untersuchungseinrichtungen, z. B. bei optischen Messstrecken, nicht tolerierbar ist.

Die US 4,954,713 offenbart eine Kühlungsvorrichtung gemäß dem Oberbegriff des Anspruchs 1.

Die JP 8-166 331 A offenbart eine Vorrichtung zur Charakterisierung von Halbleiterproben mit einer Tieftemperaturvorrichtung, die einen Tieftemperaturbehälter mit wenigstens einer Untersuchungsöffnung, eine Probenhalterung, die in dem Tieftemperaturbehälter angeordnet und an der eine zu untersuchende Probe befestigbar ist, und einer Kühleinrichtung, die thermisch mit der Probenhalterung gekoppelt ist, umfasst. Die DE 100 56 131 A1 offenbart eine Kühlvorrichtung, die einen Tieftemperaturbehälter, eine Probenhalterung, die in dem Tieftemperaturbehälter angeordnet ist und an der eine zu untersuchende Probe befestigbar ist, und einer Kühleinrichtung, die thermisch mit der Probenhalterung gekoppelt ist, umfasst. Weitere Kühlvorrichtungen, die für das Verständnis der vorliegenden Erfindung relevant sind, sind in der EP 0 585 001 A2, der GB 2 325 045 A, der GB 2 322 969 A und der EP 1 406 107 A2 offenbart.

Aus der US 5 611 207 A ist ebenfalls eine Tieftemperaturvorrichtung gemäß dem Oberbegriff des Anspruchs 1 bekannt. Die Öffnung im Tieftemperaturbehälter ist mittels einer Verschlussblende verschließbar. Die Verschlussblende ist mittels einer Gelenkverbindung mit dem Tieftemperaturbehälter verbunden.

Aus dem Artikel von Meyer G: "A Simple Low-Temperatur Ultrahigh-Vaccum Scanning Tunneling Microscope Capable of Atomic Manipulation", Review of Scientific Instruments, AIP, Melville, NY, US, Bd. 67, Nr. 8, 1. August 1996, Seiten 2960 - 2965, XP000620468 ISSN: 0034-6748, ist ein STM bekannt, bei dem in dem Temperaturbehälter eine Öffnung vorgesehen ist, durch die eine Probe in den Tieftemperaturbehälter eingeführt werden kann (siehe Fig. 2 und 3). Diese Öffnung ist in Analogie zu der US 5 611 207 A mit einer Blende verschließbar. Ein in dem Tieftemperaturbehälter angeordnetes Fenster ist starr mit der Wand des Tieftemperaturbehälters verbunden.

Auch aus der US-A-5 352 898 ist ein Rasterelektronenmikroskop bekannt, des eine seitliche Öffnung aufweist, mittels der über einen Manipulator eine Probe in das Rasterelektronenmikroskop eingeführt werden kann. Diese Öffnung ist mittels eines Absperrschiebers verschließbar.

Es ist Aufgabe der vorliegenden Erfindung, eine Tieftemperaturvorrichtung anzugeben, die die unmittelbare Verbindung von vibrationsempfindlichen Untersuchungs- und Manipuliereinrichtungen mit dem Untersuchungsfenster ermöglicht.

Die Lösung dieser Aufgabe erfolgt durch die Merkmale des Anspruch 1.

Dadurch, dass die Untersuchungsöffnung flexibel und nicht starr mit dem Tieftemperaturbehälter verbunden ist, wird verhindert, dass durch die mechanische Kühleinrichtung erzeugte Vibrationen auf die Untersuchungsöffnung übertragen werden; zumindest erfolgt eine starke Dämpfung. Damit kann eine vibrationsempfindliche Untersuchungs- und Manipulationseinrichtung direkt an die Untersuchungsöffnung angekoppelt, z. B. angeflanscht werden ohne dass Vibrationen auf die Untersuchungs- und Manipulationseinrichtung übertragen werden.

Durch die vorteilhafte Ausgestaltung der Erfindung nach Anspruch 2 wird verhindert, dass von der Kühleinrichtung erzeugte Vibrationen auf die Probenhalterung und auf eine daran befestigte Probe übertragen werden.

Durch die vorteilhafte Ausgestaltung der Erfindung nach Anspruch 4 wird die zu untersuchende Probe starr und nahezu vibrationsfrei mit der Untersuchungs- und

Manipulationseinrichtung gekoppelt. Die Untersuchung der auf der Probenhalterung angeordneten Probe kann daher ohne störende Vibrationen erfolgen.

Durch die vorteilhafte Ausgestaltung der Erfindung nach Anspruch 5 wird gewährleistet, dass Strahlung von außen auf die Probe geführt werden kann und dass von der Probe ausgehende Strahlung durch das Untersuchungsfenster in die Untersuchungs- und Manipulationseinrichtung gelangen kann.

Durch die vorteilhafte Ausgestaltung der Erfindung nach Anspruch 6 wird erreicht, dass der zu evakuierende und thermisch zu isolierende Bereich auf das Innere des Tieftemperaturbehälters beschränkt wird und nicht zusätzlich Teile der Untersuchungs- und Manipulationseinrichtung evakuiert und gekühlt werden müssen.

Durch die vorteilhafte Ausgestaltung der Erfindung nach Anspruch 7 kann die zu untersuchende Probe von zwei Seiten gleichzeitig untersucht werden, auch ist es möglich, dass die Probe von einer Seite manipuliert wird, während von der anderen Seite die Untersuchung erfolgt, indem z.B. von der Probe abgehende Strahlung erfasst wird. "Manipuliert" bedeutet auch, dass über ein Untersuchungsfenster Strahlung auf die Probe gerichtet wird, und dass über das zweite Untersuchungsfenster die von der Probe ausgehende Strahlung analysiert wird. Es können auch mehr als zwei Untersuchungsöffnungen vorgesehen werden. Die Ausgestaltung der Rohrstücke wird dann im zusammentreffenden Bereich der Probenhalterung natürlich etwas komplizierter.

Vorzugsweise wird als mechanische Kühleinrichtung ein Pulsrohrkühler eingesetzt, da dieser weniger störende Vibrationen erzeugt als andere mechanische Kühleinrichtungen. Die noch vorhandenen Vibrationen werden durch die erfindungsgemäße Anordnung der Untersuchungsöffnung unschädlich gemacht - Ansprüche 8 bis 10.

Die Kühleinrichtung kann auch ein Mischungskühl- oder ein ³He-⁴He-Mischungskühler-System umfassen.

Die übrigen Unteransprüche beziehen sich auf weitere vorteilhafte Ausgestaltungen der Erfindung.

Weitere Einzelheiten, Merkmale und Vorteile der Erfindung ergeben sich aus der nachfolgenden Beschreibung von bevorzugten Ausführungsformen anhand der Zeichnungen.

Es zeigt:
Fig. 1 eine erste beispielhafte Ausführungsform der Erfindung mit einer Untersuchungsöffnung, und
Fig. 2 eine zweite beispielhafte Ausführungsform der Erfindung mit zwei Untersuchungsöffnungen.

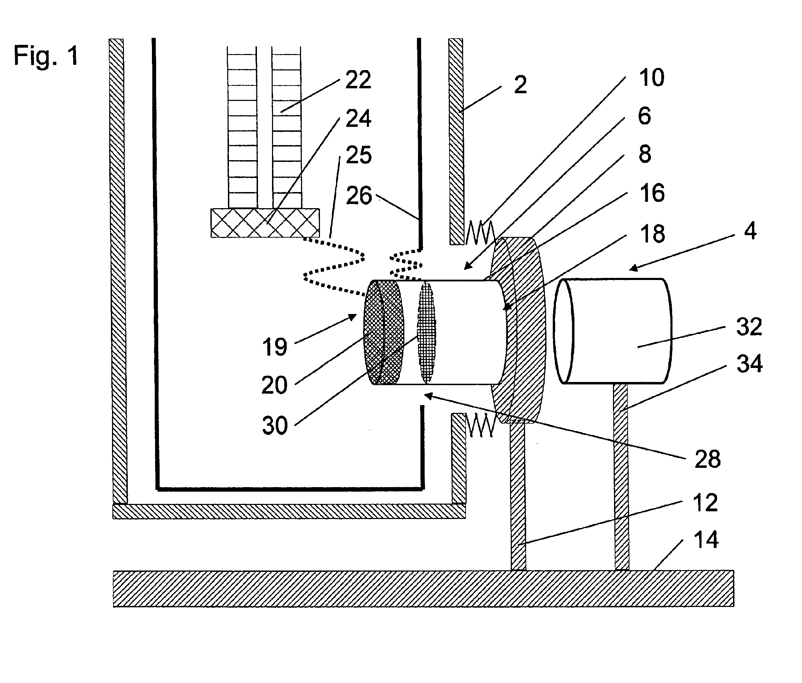

Die schematisch in Fig. 1 dargestellte erste Ausführungsform der Tieftemperatureinrichtung umfasst einen Tieftemperaturbehälter 2 in Form eines Dewar-Behälters, in dem eine verschließbare Untersuchungsöffnung 4 vorgesehen ist. Die Untersuchungsöffnung 4 umfasst eine Ausnehmung 6 in dem Tieftemperaturbehälter 2. Vor der Ausnehmung ist ein Untersuchungsfenster 8 angeordnet, das aus einem nicht näher dargestellten Flansch besteht, der eine für Strahlung in einem bestimmten Wellenlängenbereich durchlässige Scheibe umschließt. Das Untersuchungsfenster 8 ist mittels eines Faltenbalges 10 mit dem Tieftemperaturbehälter 2 verbunden und schließt die Ausnehmung 6 gasdicht ab. Das Untersuchungsfenster 8 ist starr durch eine Fensterhalterung 12 auf einem vibrationsarmen Tisch 14 angeordnet. Ein beidseitig offenes Rohrstück 16 aus einem thermisch isolierenden Material, z.B. glasfaserverstärkter Kunststoff, mit einer ersten Stirnseite 18 und einer zweiten Stirnseite 19 ist mit seiner ersten Stirnseite 18 fest mit der Innenseite des Untersuchungsfensters 8 verbunden. Auf der zweiten Stirnseite 19, die in das Innere des Tieftemperaturbehälters 2 hineinragt, ist eine Probenhalterung 20 angeordnet. Ins Innere des Tieftemperaturbehälters 2 ragt eine Kühleinrichtung 22 in Form eines Pulsrohrkühlers, der einen Kaltkopf 24 umfasst. Der Kaltkopf 24 ist thermisch mit der Probenhalterung 20 gekoppelt - Bezugszeichen 25, so dass eine auf der Probenhalterung 20 angeordnete Probe (nicht dargestellt) auf die notwendige Betriebstemperatur gekühlt werden kann. Die Probenhalterung 20 mit Probe wird im Inneren des Tieftemperaturbehälters 2 von einem Strahlungsschild 26 in Form eines 70K-Schildes umschlossen. Das 70K-Schild 26 umfasst eine Öffnung 28, die von dem Rohrstück 16 durchsetzt wird. Das Rohrstück 16 ist thermisch an das 70K-Schild 26 gekoppelt - Bezugszeichen 27. In dem Bereich des Rohrstücks 16, der in der Öffnung 28 des 70K-Schildes 26 zu liegen kommt, ist ein Schildfenster 30 vorgesehen, das ebenfalls für Strahlung von und zu der Probe durchlässig ist. Alternativ kann das Schildfenster auch weggelassen werden. Auf der Außenseite des Untersuchungsfensters 8 ist eine optische Untersuchungseinrichtung 32 angeordnet, die über eine Halterung 34 auf den vibrationsarmen Tisch 14 abgestützt ist.

Dadurch, dass das Untersuchungsfenster 8 der Untersuchungsöffnung 4 lediglich über den Faltenbalg 10 mit der Ausnehmung 6 in den Tieftemperaturbehälter 2 verbunden ist, können störende Vibrationen nicht auf das Untersuchungsfenster 8 übertragen werden. Wird beispielsweise die Untersuchungseinrichtung 32 starr mit der Außenseite des Untersuchungsfensters 8 verbunden, werden auf die Untersuchungseinrichtung 32 keine mechanische Schwingungen übertragen oder nur sehr gedämpft übertragen. Dadurch, dass die Probenhalterung 20 über das gerade Rohrstück 16 starr mit der Innenseite des Untersuchungsfensters 8 verbunden ist, ist die Probenhalterung 20 mechanisch von dem Dewar-Behälter 2 und dem Pulsrohrkühler 22 entkoppelt, obwohl die Probenhalterung 20 im Inneren des Dewar-Behälters 2 angeordnet ist. Das Untersuchungsfenster 8 und die starr damit verbundene Probenhalterung 20 sind über die Fensterhalterung 12 auf dem vibrationsarmen Tisch 14 abgestützt. Der Tieftemperaturbehälter 2 bzw. der Dewar-Behälter 2 ist nicht auf dem vibrationsarmen Tisch 14 abgestützt.

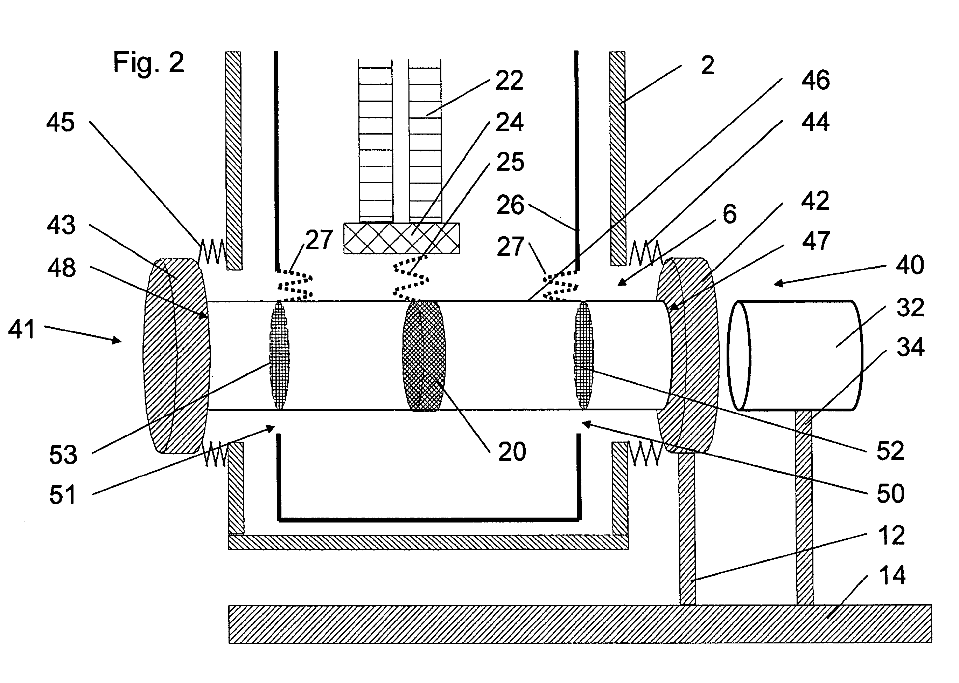

Die Ausführungsform nach Fig. 2 unterscheidet sich von der ersten Ausführungsform nach Fig. 1 dadurch, dass anstelle von einer Untersuchungsöffnung zwei einander gegenüberliegend angeordnete Untersuchungsöffnungen 40, 41 in dem Tieftemperaturbehälter 2 vorgesehen sind. Beide Untersuchungsöffnungen 40 und 41 werden durch ein erstes bzw. ein zweites Untersuchungsfenster 42 und 43 verschlossen. Die beiden Untersuchungsfenster 42, 43 sind mit einem ersten bzw. mit einem zweiten Faltenbalg 44 und 45 mit dem Tieftemperaturbehälter 2 verbunden. Zwischen den beiden Untersuchungsfenstern 42 und 43 erstreckt sich ein gerades Rohrstück 46 mit einer ersten Stirnseite 47 und einer zweiten Stirnseite 48. Die erste Stirnseite 47 kontaktiert die Innenseite des ersten Untersuchungsfensters 42, und die zweite Stirnseite 48 kontaktiert die Innenseite des zweiten Untersuchungsfensters 43. Das beidseitig offene Rohrstück 46 besteht aus thermisch isolierendem Material, z. B. aus GFK. Das erste Untersuchungsfenster 42 ist auf einem vibrationsarmen Tisch 14 abgestützt. Über das Rohrstück 46 ist das zweite Untersuchungsfenster 43 starr mit dem ersten Untersuchungsfenster 42 verbunden. Dadurch erübrigt sich eine zusätzliche Abstützung des zweiten Untersuchungsfensters 43 auf dem vibrationsarmen Tisch 14. Das zweite Untersuchungsfenster 43 kann aber in analoger Weise zu dem ersten Untersuchungsfenster 42 über eine Halterung auf dem vibrationsarmen Tisch 14 abgestützt werden.

In etwa in der Mitte des Rohrstücks 46 ist die eine Probenhalterung 20 angeordnet, die thermisch an einen Kaltkopf 24 gekoppelt ist. Die auf der Probenhalterung 20 angeordnete Probe ist durch beide Untersuchungsfenster 40, 41 einsehbar. Wie bei der ersten Ausführungsform nach Fig. 1 ist ebenfalls ein 70K-Schild 26 zur thermischen Isolierung des Bereichs des Kaltkopfes 24 und der Probenhalterung 20 vorgesehen. Das 70K-Schild 26 umfasst eine erste und eine zweite Öffnung 50 und 51, die von dem Rohrstück 46 durchsetzt wird. In den zwei Bereichen des Rohrstücks 46, die in der ersten und zweiten Öffnung 50 und 51 des 70K-Schildes 26 zu liegen kommt, ist ein erstes bzw. ein zweites Schildfenster 52 und 53 vorgesehen, die ebenfalls für Strahlung von und zu der Probe durchlässig ist. Alternativ können die Schildfenster auch weggelassen werden. Das 70K-Schild 26 ist thermisch mit dem Rohrstück 46 gekoppelt. Vor dem ersten Untersuchungsfenster 40 ist eine optische Untersuchungsvorrichtung 30 angeordnet, die auf dem vibrationsarmen Tisch 14 abgestützt ist.

Bei der vorliegenden Erfindung werden die Komponenten, die in Messungen und Untersuchungen einbezogen sind, die empfindlich gegenüber Vibrationen sind, auf dem vibrationsarmen Tisch 14 abgestützt. Die Verbindung zu den "vibrierenden" Komponenten der Tieftemperaturvorrichtung erfolgt über flexible Elemente, insbesondere mittels Faltenbälgen. Dadurch werden die vibrierenden Komponenten der Tieftemperaturvorrichtung hinsichtlich mechanischer Schwingungen und Vibrationen von der Untersuchungs- und Messanordnung entkoppelt.

Bei den beiden beschriebenen Ausführungsformen ist jeweils ein 70K-Schild 26 vorgesehen. Es können auch mehrere Strahlungsschilde für unterschiedliche Temperaturen vorgesehen werden.

Die Schildfenster 30, 52, 53 bestehen vorzugsweise aus dem gleichen Material wie die Untersuchungsfenster 8, 42 und 43. Die Schildfenster 52 und 43 können ebenso wie die beiden Untersuchungsfenster 42 und 43 aus unterschiedlichen Materialien bestehen, die für Strahlung mit unterschiedlicher Wellenlänge durchlässig sind.

### Bezugszeichenliste:

- 2: Tieftemperaturbehälter
- 4: Untersuchungsöffnung
- 6: Ausnehmung in 2
- 8: Untersuchungsfenster
- 10: Faltenbalg
- 12: Fensterhalterung
- 14: vibrationsarmer Tisch
- 16: Rohrstück
- 18: erste Stirnseite von 16
- 19: zweite Stirnseite von 16
- 20: Probenhalterung
- 22: Pulsrohrkühler
- 24: Kaltkopf
- 25: thermische Kopplung
- 26: 70K-Schild
- 27: thermische Kopplung
- 28: Öffnung in 26
- 30: Schildfenster
- 32: optische Untersuchungseinrichtung
- 34: Halterung von 32

- 40: erste Untersuchungsöffnungen
- 41: zweite Untersuchungsöffnung
- 42: erstes Untersuchungsfenster
- 43: zweites Untersuchungsfenster
- 44: erster Faltenbalg
- 45: zweiter Faltenbalg
- 46: gerades Rohrstück
- 47: erste Stirnseite
- 48: zweite Stirnseite
- 50: erste Öffnung in 26
- 51: zweite Öffnung in 26
- 52: erstes Schildfenster
- 53: zweites Schildfenster

## Patentansprüche

1. Tieftemperaturvorrichtung mit
einem Tieftemperaturbehälter (2) mit wenigstens einer Untersuchungsöffnung (4; 40, 41)
einer Probenhalterung (20), die in dem Tieftemperaturbehälter (2) angeordnet ist und an der ein zu untersuchende Probe befestigbar ist, und
einer Kühleinrichtung (22), die thermisch mit der Probenhalterung (20) gekoppelt ist, **dadurch gekennzeichnet,**
**dass** die wenigstens eine Untersuchungsöffnung (4; 40, 41) flexibel mit dem Tieftemperaturbehälter (2) verbunden ist, um durch die Kühleinrichtung erzeugte Vibrationen zu dämpfen.

2. Tieftemperaturvorrichtung nach Anspruch 1, **dadurch gekennzeichnet, dass** die Probenhalterung (20) flexibel mit der Kühleinrichtung gekoppelt ist.

3. Tieftemperaturvorrichtung nach Anspruch 1 oder 2, **dadurch gekennzeichnet, dass** die Kühleinrichtung (22) einen Kaltkopf (24) umfasst, der thermisch mit der Probenhalterung (20) gekoppelt ist.

4. Tieftemperaturvorrichtung nach einem der vorhergehenden Ansprüche, **dadurch gekennzeichnet, dass** die Probenhalterung (20) starr mit der Untersuchungsöffnung (4; 40, 41) verbunden ist.

5. Tieftemperaturvorrichtung nach einem der vorhergehenden Ansprüche, **dadurch gekennzeichnet, dass** durch die wenigstens eine Untersuchungsöffnung (4; 40, 41) eine an der Probenhalterung (20) befestigte Probe einsehbar ist.

6. Tieftemperaturvorrichtung nach einem der vorhergehenden Ansprüche, **dadurch gekennzeichnet, dass** die wenigstens eine Untersuchungsöffnung (4; 40, 41) durch ein Untersuchungsfenster (8; 42, 43) verschlossen ist, und dass das Untersuchungsöffnung (4; 40, 41) für Strahlung in einen bestimmten Wellenlängenbereich durchlässig ist, so dass durch dieses Untersuchungsöffnung (4; 40, 41) Strahlung in diesem bestimmten Wellenlängenbereich von oder zu einer Probe führbar ist, die an der Probenhalterung (20) befestigbar ist.

7. Tieftemperaturvorrichtung nach einem der vorhergehenden Ansprüche, **dadurch gekennzeichnet, dass** in dem Tieftemperaturbehälter (2) eine erste und eine zweite Untersuchungsöffnung (40, 41) vorgesehen sind, die an einander gegenüberliegenden Seiten des Tieftemperaturbehälters (2) ausgebildet sind.

8. Tieftemperaturvorrichtung nach einem der vorhergehenden Ansprüche, **dadurch gekennzeichnet, dass** die Kühleinrichtung eine mechanische Kühleinrichtung (22) umfasst.

9. Tieftemperaturvorrichtung nach Anspruch 8, **dadurch gekennzeichnet, dass** die Kühleinrichtung einen Pulsrohrkühler (22) umfasst.

10. Tieftemperaturvorrichtung nach Anspruch 9, **dadurch gekennzeichnet, dass** der Pulsrohrkühler ein zweistufiger Pulsrohrkühler (22) ist.

## Claims

1. A low temperature device comprising:
a low temperature container (2) comprising at least one test opening (4; 40, 41);
a probe holder (20) disposed inside the low temperature container (2), and wherein a probe that is to be investigated can be attached to the probe holder (20); and
a cooling device (22) that is thermally coupled to the probe holder (20); **characterized in**
**that** the at least one test opening (4; 40, 41) is flexibly connected to the low temperature container (2) to damp vibrations produced by the cooling device (22).

2. The low temperature device according to claim 1, **characterized in that** the probe holder (20) is flexibly coupled to the cooling device (22).

3. The low temperature device according to claim 1 or 2, **characterized in that** the cooling device (22) includes a cooling head (24) that is thermally coupled to the probe holder (20).

4. The low temperature device according to one of the preceding claims, **characterized in that** the probe holder (20) is rigidly connected to the test opening (4; 40, 41).

5. The low temperature device according to one of the preceding claims, **characterized in that** a probe that is attached to the probe holder (20) is visible through the at least one test opening (4; 40, 41).

6. The low temperature device according to one of the preceding claims, **characterized in that** the at least one test opening (4; 40, 41) is closed by a test window (8; 42, 43), and **in that** the test opening (4; 40, 41) is permeable to radiation of a predetermined wavelength such that radiation of the predetermined wavelength can be directed through this test window (8; 42, 43) to the probe that can be attached to the probe holder (20).

7. The low temperature device according to one of the preceding claims, **characterized in that** a first and a second test opening (40, 41) are provided in the low temperature container (2), and wherein the first and second test openings (40, 41) are disposed on opposite sides of the low temperature container (2).

8. The low temperature device according to one of the preceding claims, **characterized in that** the cooling device (22) includes a mechanical cooling device (22).

9. The low temperature device according to claim 8, **characterized in that** the cooling device (22) includes a pulsed tube cooler (22).

10. The low temperature device according to claim 9, **characterized in that** the pulsed tube cooler is a two-stage pulsed tube cooler (22).

## Revendications

1. Dispositif basse température comprenant
un réservoir basse température (2) pourvu d'au moins une ouverture d'analyse (4 ; 40, 41),
un porte-échantillon (20), qui est disposé dans le réservoir basse température (2) et au niveau duquel un échantillon à analyser peut être fixé, et
un système de refroidissement (22), qui est couplé thermiquement au porte-échantillon (20),
**caractérisé en ce**
**que** l'ouverture d'analyse (4 ; 40, 41) au moins au nombre de une est reliée de manière flexible au réservoir basse température (2) afin d'amortir des vibrations produites par le système de refroidissement.

2. Dispositif basse température selon la revendication 1, **caractérisé en ce que** le porte-échantillon (20) est couplé de manière flexible au système de refroidissement.

3. Dispositif basse température selon la revendication 1 ou 2, **caractérisé en ce que** le système de refroidissement (22) comprend une tête froide (24), qui est couplée thermiquement au porte-échantillon (20).

4. Dispositif basse température selon l'une quelconque des revendications précédentes, **caractérisé en ce que** le porte-échantillon (20) est relié de manière rigide à l'ouverture d'analyse (4 ; 40, 41).

5. Dispositif basse température selon l'une quelconque des revendications précédentes, **caractérisé en ce qu'**un échantillon fixé au niveau du porte-échantillon (20) peut être vu par l'ouverture d'analyse (4 ; 40, 41) au moins au nombre de une.

6. Dispositif basse température selon au moins l'une quelconque des revendications précédentes, **caractérisé en ce que** l'ouverture d'analyse (4 ; 40, 41) au moins au nombre de une est fermée par une fenêtre d'analyse (8 ; 42, 43), et **en ce que** l'ouverture d'analyse (4 ; 40, 41) laisse passer un rayonnement relevant d'une plage de longueurs d'onde définie de sorte qu'un rayonnement relevant de ladite plage de longueurs d'onde définie peut être guidé depuis ou vers un échantillon par ladite ouverture d'analyse (4 ; 40, 41), lequel échantillon peut être fixé au niveau du porte-échantillon (20).

7. Dispositif basse température selon l'une quelconque des revendications précédentes, **caractérisé en ce qu'**une première et une deuxième ouverture d'analyse (40, 41) sont prévues dans le réservoir basse température (2), lesquelles sont réalisées au niveau de côtés se faisant face du réservoir basse température (2).

8. Dispositif basse température selon l'une quelconque des revendications précédentes, **caractérisé en ce que** le système de refroidissement comprend un système de refroidissement mécanique (22).

9. Dispositif basse température selon la revendication 8, **caractérisé en ce que** le système de refroidissement comprend un refroidisseur à tube pulsé (22).

10. Dispositif basse température selon la revendication 9, **caractérisé en ce que** le refroidisseur à tube pulsé est un refroidisseur à tube pulsé (22) à deux étages.
